# EUROPEAN PATENT APPLICATION

(11) **EP 3 522 145 A1**
(43) Date of publication of application: **07.08.2019**
(21) Application number: 17825089.0
(22) Date of filing: 24.05.2017
(51) Int. Cl.: G09G 3/34, H01L 27/32, G09G 3/36, G09G 3/3208

(54) **DISPLAY DEVICE AND METHOD FOR CONTROLLING BRIGHTNESS OF DISPLAY DEVICE**

(30) Priority: 19.09.2016 CN 201610830611
(71) Applicant: BOE Technology Group Co., Ltd., Beijing 100015 (CN)
(72) Inventor: XIAO, Li, Beijing 100176 (CN); CHEN, Xiaochuan, Beijing 100176 (CN); YANG, Shengji, Beijing 100176 (CN); LIU, Dongni, Beijing 100176 (CN); WANG, Lei, Beijing 100176 (CN); FU, Jie, Beijing 100176 (CN); LU, Pengcheng, Beijing 100176 (CN); YUE, Han, Beijing 100176 (CN)
(74) Representative: Gesthuysen Patent- und Rechtsanwälte
(86) International application number: PCT/CN2017/085698
(87) International publication number: WO 2018/049840

(57) **Abstract**

Embodiments of the present disclosure provide a display device and a method for controlling brightness of the display device. The display device may comprise: a first substrate and a second substrate arranged opposite to each other; a reflecting member disposed on a side of the first substrate near the second substrate; a light intensity detector disposed on a side of the second substrate near the first substrate and configured to sense light intensity of light reflected by the reflecting member; and a controller electrically connected to the light intensity detector and configured to control brightness of the display device according to the light intensity sensed by the light intensity detector. By means of the display device and the method for controlling brightness of the display device according to the embodiments of the present disclosure, brightness of the display device can be better controlled so as to improve display quality.

## Description

### Technical Field

The present disclosure relates to a display technology, in particular to a display device and a method for controlling brightness of the display device.

### Background

With the rapid development of electronic devices like smart phones and tablet PCs, higher requirements are imposed on display qualities of display devices. In order to improve display quality, brightness of the display device usually needs to be controlled so as to display images at appropriate brightness.

The existing ways of controlling brightness of the display device include separately making an additional sensing unit, sensing ambient light, and so on. But they cannot achieve accurate sensing of the light intensity and require complex processes, thus increasing the cost for manufacturing the display device.

### Summary

Therefore, it is desirable to provide an improved display device and a method for controlling brightness of the display device, which can alleviate or avoid one or more of the above-mentioned problems.

According to an aspect of the present disclosure, a display device is provided, which comprises:
a first substrate and a second substrate arranged opposite to each other;
a reflecting member disposed on a side of the first substrate near the second substrate;
a light intensity detector disposed on a side of the second substrate near the first substrate and configured to sense light intensity of light reflected by the reflecting member; and
a controller electrically connected to the light intensity detector, which is configured to control brightness of the display device according to the light intensity sensed by the light intensity detector.

According to an embodiment of the present disclosure, the controller compares the light intensity sensed by the light intensity detector to a predefined range of light intensity, and if the light intensity sensed by the light intensity detector is within the predefined range of light intensity, the controller keeps the brightness of the display device, and if the light intensity sensed by the light intensity detector is outside the predefined range of light intensity, the controller adjusts the brightness of the display device so that the light intensity sensed by the light intensity detector falls within the predefined range of light intensity. Moreover, the light intensity sensed by the light intensity detector can be displayed by the display device.

According to another embodiment of the present disclosure, the display device can be a liquid crystal display device, and the first substrate is a color film substrate, the second substrate is an array substrate.

Further, the liquid crystal display device may further comprise a backlight source arranged on a side of the array substrate facing away from the color film substrate and a backlight driver for driving the backlight source. The light intensity detector senses light intensity of the light emitted from the backlight source and reflected by the reflecting member, and the controller controls the backlight driver according to a result of comparison between the light intensity sensed by the light intensity detector and the predefined range of light intensity so as to adjust light intensity of the backlight source.

According to another embodiment of the present disclosure, the liquid crystal display device includes a display area and a peripheral area, and both the reflecting member and the light intensity detector are arranged in the peripheral area.

According to another embodiment of the present disclosure, the liquid crystal display device includes a display area and a peripheral area. The display area includes a plurality of pixel regions, an edge region of each pixel region being provided with the reflecting member and the light intensity detector.

According to another embodiment of the present disclosure, the display device can be an OLED display device, and the first substrate is an encapsulation substrate and the second substrate is an array substrate.

Further, the array substrate comprises an OLED and a driver for driving the OLED. The light intensity detector senses light intensity of light emitted from the OLED and reflected by the reflecting member, and the controller controls the driver according to a result of comparison between the light intensity sensed by the light intensity detector and the predefined range of light intensity so as to adjust light intensity of the light emitted by the OLED.

According to another embodiment of the present disclosure, the OLED display device has a display area and a peripheral area. The display area includes a plurality of pixel regions, an edge region of each pixel region being provided with the reflecting member and the light intensity detector.

According to another embodiment of the present disclosure, the OLED display device has a display area and a peripheral area, and the reflecting member and the light intensity detector are both arranged in the peripheral area.

According to another aspect of the present disclosure, a method for controlling brightness of the display device is provided, which comprises:
sensing, by a light intensity detector arranged on a second substrate of the display device, light intensity of light reflected by a reflecting member on a first substrate; and
controlling, by a controller electrically connected to the light intensity detector, brightness of the display device according to the light intensity sensed by the light intensity detector.

According to another embodiment of the present disclosure, said controlling, by a controller electrically connected to the light intensity detector, brightness of the display device according to the light intensity sensed by the light intensity detector comprises:
comparing, by the controller, the light intensity sensed by the light intensity detector to a predefined range of light intensity;
if the light intensity sensed by the light intensity detector is within the predefined range of light intensity, keeping the brightness of the display device by the controller, and if the light intensity sensed by the light intensity detector is outside the predefined range of light intensity, adjusting the brightness of the display device by the controller so that the light intensity sensed by the light intensity detector falls within the predefined range of light intensity.

According to another embodiment of the present disclosure, said method further comprises displaying, on the display device, the light intensity of the light reflected by the reflecting member and sensed by the light intensity detector.

According to another embodiment of the present disclosure, the display device can be a liquid crystal display device which comprises a backlight source and a backlight driver for driving the backlight source. The light intensity detector senses light intensity of the light emitted from the backlight source and reflected by the reflecting member, and the controller controls the backlight driver according to a result of comparison between the light intensity sensed by the light intensity detector and the predefined range of light intensity so as to adjust light intensity of the backlight source.

According to another embodiment of the present disclosure, the display device can be an OLED display device which comprises an OLED and a driver for driving the OLED. The light intensity detector senses light intensity of the light emitted from the OLED and reflected by the reflecting member, and the controller controls the driver according to a result of comparison between the light intensity sensed by the light intensity detector and the predefined range of light intensity so as to adjust light intensity of the light emitted by the OLED.

### Brief Description of the Drawings

The concept and other advantages of the present disclosure will now be described through non-limiting embodiments with reference to the drawings.
Fig. 1 is a schematic drawing of a display device according to an embodiment of the present disclosure;
Fig. 2 is a schematic drawing of a liquid crystal display device according to an embodiment of the present disclosure;
Fig. 3 is a plane graph of an array substrate of a liquid crystal display device according to an embodiment of the present disclosure;
Fig. 4 is a plane graph of an array substrate of a liquid crystal display device according to another embodiment of the present disclosure;
Fig. 5 is a schematic drawing of an OLED display device according to an embodiment of the present disclosure;
Fig. 6 shows a method for controlling brightness of the display device according to an embodiment of the present disclosure.

### Detailed Description

Specific examples of the display device and method for controlling brightness of the display device according to embodiments of the present disclosure will be described below with reference to the drawings. The drawings are schematic and are thus not drawn to scale, and they only intend to illustrate embodiments of the present disclosure rather than limiting the protection scope of the present disclosure.

It shall be understood that when one element or layer is asserted to be "on", "above", "connected to" or "coupled to" another element or layer, it may be directly on, above, connected to or coupled to said another element or layer, or there may be elements or layers interposed therebetween. On the contrary, when one element is asserted to be "directly on", "directly connected to" or "directly coupled to" another element or layer, there is no interposed element or layer.

As mentioned above, the existing ways of controlling brightness of the display device include separately making an additional sensing unit, sensing ambient light, and so on. But they cannot achieve accurate sensing of the light intensity and require complex processes, thus increasing the cost for manufacturing the display device.

In view of the above problems in the existing display device, embodiments of the present disclosure provide an improved display device.

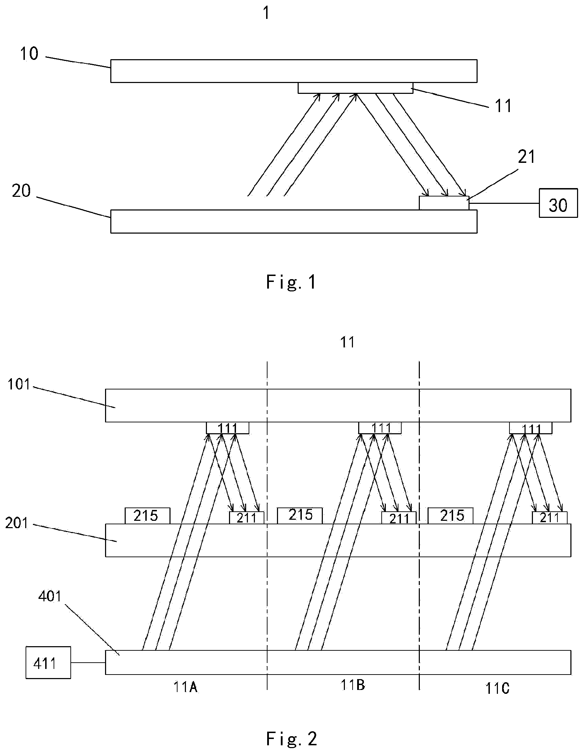

Fig. 1 is a schematic drawing of a display device according to an embodiment of the present disclosure.

As shown in Fig. 1, a display device 1 according to an embodiment of the present disclosure comprises a first substrate 10 and a second substrate 20 arranged opposite to each other, a reflecting member 11, a light intensity detector 21, and a controller 30 electrically connected to the light intensity detector 21. The reflecting member 11 is disposed on a side of the first substrate 10 near the second substrate 20. The light intensity detector 21 is disposed on a side of the second substrate 20 near the first substrate 10 and is configured to sense light intensity of light reflected by the reflecting member 11. The controller 30 is configured to control brightness of the display device 1 according to the light intensity sensed by the light intensity detector 21.

In the display device shown in Fig. 1, the reflecting member 11 can be made of any material, such as a metal, that is capable of reflecting light. The light intensity detector 21 can, for example, be a light intensity sensor and can include a metal layer and a photosensitive material layer formed on the metal layer. The controller 30 can be arranged in an area other than the area where the first substrate 10 and the second substrate 10 are located. The controller 30 can, for example, be realized by an ASIC, a single chip machine, etc.

In the above-mentioned display device, light (e.g. light inside the display device) can be directly sensed by the reflecting member and the light intensity detector disposed on the first and second substrates arranged opposite to each other, and brightness of the display device can be controlled according to a result of sensing. Hence, compared to the way of sensing the ambient light, it can sense the light intensity more accurately, which can facilitate better control of the brightness of the display device, thereby improving display quality. In addition, since the reflecting member and the light intensity detector are directly disposed on the first and second substrates, the reflecting member and the light intensity detector can be made in the process for manufacturing the substrates and it is unnecessary to separately make an additional sensing unit. Therefore, the time of process and the cost of manufacturing are saved.

In addition, in the case of a transparent display device where users can see objects or images behind the display device through the screen, said display device can monitor the light intensity so as to match the light intensity of the displayed images to light of the objects behind the display device, thereby better realizing transparent display.

According to an embodiment of the present disclosure, the controller 30 can compare the light intensity sensed by the light intensity detector 21 to a predefined range of light intensity, and control brightness of the display device 1 according to the result of comparison. For example, if the light intensity sensed by the light intensity detector 21 is within the predefined range of light intensity, the controller 30 keeps the brightness of the display device 1, and if the light intensity sensed by the light intensity detector 21 is outside the predefined range of light intensity, the controller 30 adjusts the brightness of the display device 1 so that the light intensity sensed by the light intensity detector 21 falls within the predefined range of light intensity. The predefined range of light intensity can be set according to the specific application and/or demand so as to better control the brightness of the display device and improve display quality. For example, in case the display device is a liquid crystal display device, the predefined range of light intensity can be an initial range of the backlight intensity or a desired range of the backlight intensity of said liquid crystal display device. In case the display device is an OLED display device, the predefined range of light intensity can, for example, be an initial range of the luminous intensity or a desired range of the luminous intensity of said OLED display device. The predefined range of light intensity can be set by those skilled in the art according to the application and/or demand, which is not limited herein.

According to another embodiment of the present disclosure, the light intensity sensed by the light intensity detector 21 can be displayed by the display device 1. By using the display device itself to display the result of sensing of the light intensity detector, users can learn more directly the brightness condition of the display device.

Fig. 2 is a schematic drawing of a liquid crystal display device according to an embodiment of the present disclosure.

As shown in Fig. 2, according to an embodiment of the present disclosure, the display device can be a liquid crystal display device 11. In the liquid crystal display device 11, the first substrate is a color film substrate 101, the second substrate is an array substrate 201. The liquid crystal display device 11 may further comprise a backlight source 401 arranged on a side of the array substrate 201 facing away from the color film substrate 101 and a backlight driver 411 for driving the backlight source 401. The light intensity detector 211 senses light intensity of the light emitted from the backlight source 401 and reflected by the reflecting member 111. The controller (not shown in the figure) controls the backlight driver 411 according to a result of comparison between the light intensity sensed by the light intensity detector 211 and the predefined range of light intensity so as to adjust light intensity of the backlight source 401.

By using the light intensity detector arranged on the array substrate to sense the light intensity of light emitted from the backlight source and reflected by the reflecting member arranged on the color film substrate, backlight transmittance can be sensed accurately and the intensity of backlight can be adjusted according to the sensing result. Therefore, brightness of the display device can be better controlled so as to improve display quality. Moreover, the backlight intensity can be reduced if a high backlight intensity is unnecessary, thereby reducing power consumption.

For example, the controller compares the light intensity sensed by the light intensity detector 211 to a predefined range of light intensity. If the light intensity sensed by the light intensity detector 211 is within the predefined range of light intensity, the controller keeps the brightness of the liquid crystal display device 11. If the light intensity sensed by the light intensity detector 211 is outside the predefined range of light intensity, the controller can process data input by the light intensity detector 211 and then feedback compensation parameters to the backlight driver 411 to adjust light intensity of the backlight source 401, as a result, brightness of the liquid crystal display device 11 can be adjusted so that the light intensity sensed by the light intensity detector 211 is within the predefined range of light intensity. Therefore, the backlight intensity can be monitored and adjusted.

The light intensity detector 211 can, for example, include a metal layer and a photosensitive material layer formed on the metal layer, wherein the metal layer can, for example, be arranged at the same layer as data lines included in the array substrate 201. The light intensity detector 211 can be made in the process of manufacturing the array substrate 201 without the need to separately making an additional sensing unit. While as for the reflecting member 111, before making a black matrix of the color film substrate 101, a metal layer may be formed as the reflecting member. Hence, the reflecting member can be made in the process of manufacturing the color film substrate 101 without the need to separately making it. Both the reflecting member and the light intensity detector can be made in the process for manufacturing the substrates and they do not need to be separately made, so the time of process and the cost of manufacturing are saved.

According to an embodiment of the present disclosure, the liquid crystal display device 11 may include a display area and a peripheral area. As shown in Fig. 2, the display area may include a plurality of pixel regions 11A, 11B and 11C. Each pixel region may include a thin film transistor 215 and an edge area of each pixel region is provided with a reflecting member 111 and a light intensity detector 211. For example, the light intensity detector 211 can be arranged on an array substrate 201 at the edge area of each pixel region, and the reflecting member 111 can be arranged at a position on the color film substrate 101 corresponding to the light intensity detector 211, so that the light intensity detector 211 can sense light intensity of light emitted from the backlight source 410 and reflected by the reflecting member 111. By arranging the reflecting member 111 and the light intensity detector 211 at the edge area of each pixel region, reduction of aperture ratio caused by arrangement of the reflecting member and the light intensity detector can be alleviated or avoided.

For the sake of clarity, Fig. 2 only shows three pixel regions, but the number of pixel regions in the display area of the liquid crystal display device is not limited to three.

In the case where the edge area of each pixel region is provided with the reflecting member and the light intensity detector, the controller can perform, for example, data processing on light intensities sensed by respective light intensity detectors 211, and compare a result of data processing to the predefined range of light intensity. If the result of data processing of the light intensities sensed by the respective light intensity detectors 211 is within the predefined range of light intensity, the controller keeps the brightness of the liquid crystal display device 11. If the result of data processing of the light intensities sensed by the respective light intensity detectors 211 is outside the predefined range of light intensity, the controller can calculate compensation parameters according to the result of data processing of the light intensities sensed by the respective light intensity detectors 211 and feedback said compensation parameters to the backlight driver 411 to adjust light intensity of the backlight source 401, thereby adjusting brightness of the liquid crystal display device 11. As a result, the backlight intensity can be monitored and adjusted. According to the specific application and demand, appropriate algorithms can be used to realize data processing of the light intensities sensed by the respective light intensity detectors 211 and calculation of the compensation parameters.

According to another embodiment of the present disclosure, the liquid crystal display device may include a display area and a peripheral area. The display area may include a plurality of pixel regions. Both the reflecting member and the light intensity detector are arranged in the peripheral area so as to avoid blocking of the display area.

According to another embodiment of the present disclosure, the light intensity sensed by the light intensity detector 211 can also be displayed by the liquid crystal display device 11.

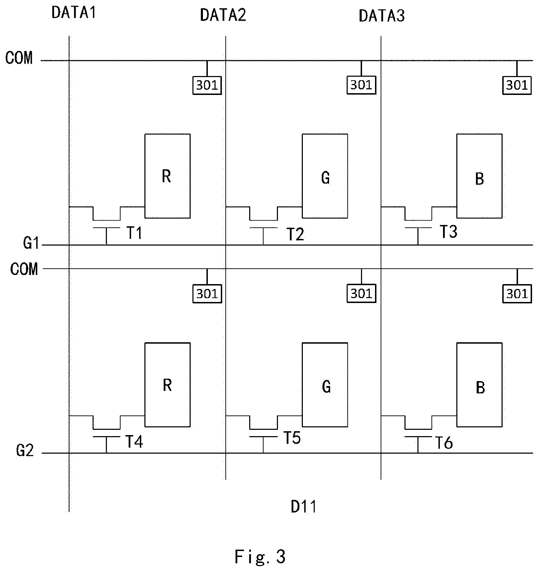

Fig. 3 is a plane graph of an array substrate of a liquid crystal display device according to an embodiment of the present disclosure.

As shown in Fig. 3, the array substrate of the liquid crystal display device may include, for example, a plurality of pixel electrodes R, G, B in a plurality of pixel regions of a display area D11; a plurality of thin film transistors T1, T2, T3, T4, T5, T6 respectively and electrically connected to the plurality of pixel electrodes; a plurality of gate lines G1, G2; a plurality of data lines DATA1, DATA2, DATA3; common electrodes COM; and a light intensity detector 301 in the edge area of each pixel region. The common electrodes COM can be electrically connected to the light intensity detector 301 so as to provide a reference voltage to the light intensity detector 301.

It shall be noted that Fig. 3 is only a schematic drawing for illustrating the embodiment of the present disclosure more clearly. The number of pixel electrodes, thin film transistors, gate lines, data lines and common electrodes included in the array substrate is not limited to that shown in Fig. 3. By arranging the light intensity detector 301 at the edge area of each pixel region, reduction of aperture ratio caused by arrangement of the light intensity detector can be alleviated or avoided.

In addition, the liquid crystal display device according to the embodiment of the present disclosure is not limited to that shown in Fig. 3. Specific modes of the liquid crystal display device, such as ADS, IPS and TN modes, can be selected according to the needs.

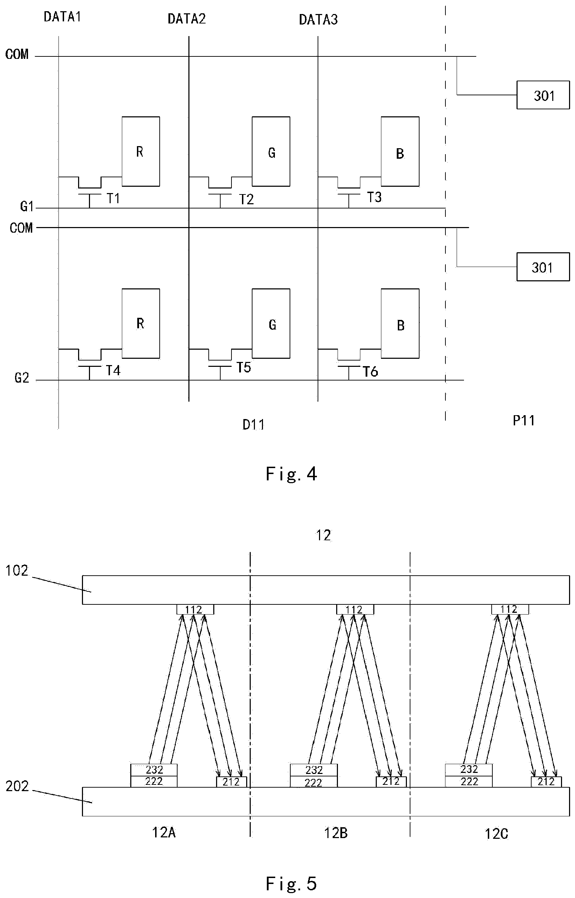

Fig. 4 is a plane graph of an array substrate of a liquid crystal display device according to another embodiment of the present disclosure.

As shown in Fig. 4, the array substrate of the liquid crystal display device may include, for example, a plurality of pixel electrodes R, G, B in a plurality of pixel regions of a display area D11; a plurality of thin film transistors T1, T2, T3, T4, T5, T6 respectively and electrically connected to the plurality of pixel electrodes; a plurality of gate lines G1, G2; a plurality of data lines DATA1, DATA2, DATA3; common electrodes COM; and a light intensity detector 301 in a peripheral area P11. The common electrodes COM can be electrically connected to the light intensity detector 301 so as to provide a reference voltage to the light intensity detector 301.

It shall be noted that Fig. 4 is only a schematic drawing for illustrating the embodiment of the present disclosure more clearly. The number of pixel electrodes, thin film transistors, gate lines, data lines and common electrodes included in the array substrate is not limited to that shown in Fig. 3. Moreover, as shown in Fig. 4, the liquid crystal display device according to the embodiment of the present disclosure may comprise a plurality of light intensity detectors. By providing a plurality of light intensity detectors, light intensity can be monitored more accurately. The number and positions of the light intensity detectors can be chosen according to the specific application and/or demand.

In addition, the liquid crystal display device according to the embodiment of the present disclosure is not limited to that shown in Fig. 4. Specific modes of the liquid crystal display device, such as ADS, IPS and TN modes, can be selected according to the needs.

Fig. 5 is a schematic drawing of an OLED display device according to an embodiment of the present disclosure.

As shown in Fig. 5, according to an embodiment of the present disclosure, the display device may be an OLED display device 12. In the OLED display device 12, the first substrate is an encapsulation substrate 102, and the second substrate is an array substrate 202. The array substrate 202 may include an OLED 232 and a driver 222 for driving the OLED 232. A light intensity detector 212 senses light intensity of light emitted from the OLED 232 and reflected by a reflecting member 112. A controller (not shown in the figure) controls the driver 222 according to a result of comparison between the light intensity sensed by the light intensity detector 212 and the predefined range of light intensity so as to adjust light intensity of the light emitted by the OLED 232. For example, the driver 222 for driving the OLED 232 can be a driving transistor. The controller can control intensity of current supplied from the driving transistor to the OLED according to the result of comparison between the light intensity sensed by the light intensity detector 212 and the predefined range of light intensity so as to adjust light intensity of the light emitted by the OLED.

By using the light intensity detector arranged on the array substrate to sense the light intensity of light emitted from the OLED and reflected by the reflecting member arranged on the encapsulation substrate, light intensity of the light emitted from the OLED can be sensed accurately and the luminous intensity of the OLED can be controlled according to a result of comparison between the sensing result and the predefined range of light intensity. Therefore, brightness of the OLED display device can be better controlled so as to improve display quality. Moreover, the luminous intensity of the OLED can be reduced if a high brightness display is unnecessary, thereby reducing power consumption.

The light intensity detector 212 can, for example, include a metal layer and a photosensitive material layer formed on the metal layer, wherein the metal layer can, for example, be arranged at the same layer as metal lines included in the array substrate 202. The light intensity detector 212 can be made in the process of manufacturing the array substrate 202 without the need to separately making an additional sensing unit. While as for the reflecting member 112, a metal layer may be formed on a base of the encapsulation substrate as the reflecting member. Hence, the reflecting member can be made in the process of manufacturing the encapsulation substrate 102 without the need to separately making it. Both the reflecting member and the light intensity detector can be made in the process for manufacturing the substrates and they do not need to be separately made, so the time of process and the cost of manufacturing are saved.

As for the OLED display device, a reference voltage can be provided to the light intensity detector by a reference voltage VDD. When the driver for driving the OLED is a driving transistor, said reference voltage VDD can also be input to a source of the driving transistor.

The OLED display device may include a display area and a peripheral area. As shown in Fig. 5, the display area includes a plurality of pixel regions 12A, 12B and 12C. Each pixel region includes an OLED 232 and a driver 222 for driving the OLED 232. An edge area of each pixel region is provided with a reflecting member 112 and a light intensity detector 212. For example, the light intensity detector 212 can be arranged on an array substrate 202 at the edge area of each pixel region, and the reflecting member 112 can be arranged at a position on the encapsulation substrate 102 corresponding to the light intensity detector 212, so that the light intensity detector 212 can sense light intensity of light emitted from the OLED 232 and reflected by the reflecting member 112. By arranging the light intensity detector in each pixel region, light intensity of light emitted from the OLED in each pixel region can be sensed, so that brightness of each pixel of the OLED display device can be adjusted independently. In addition, by arranging the reflecting member 112 and the light intensity detector 212 at the edge area of each pixel region, reduction of aperture ratio caused by arrangement of the reflecting member and the light intensity detector can be alleviated or avoided.

According to another embodiment of the present disclosure, the OLED display device may include a display area and a peripheral area. The display area may include a plurality of pixel regions. Both the reflecting member and the light intensity detector are arranged in the peripheral area so as to avoid blocking of the display area.

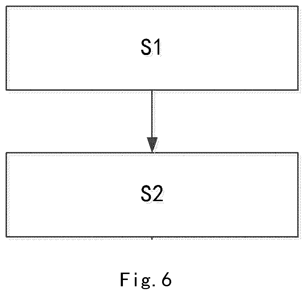

Fig. 6 shows a method for controlling brightness of the display device according to an embodiment of the present disclosure.

As shown in Fig. 6, the method for controlling brightness of the display device according to the embodiment of the present disclosure may comprise the following steps:
S1: sensing, by a light intensity detector arranged on a second substrate of the display device, light intensity of light reflected by a reflecting member on a first substrate; and
S2: controlling, by a controller electrically connected to the light intensity detector, brightness of the display device according to the light intensity sensed by the light intensity detector.

Further, step S2 may include:
comparing, by the controller, the light intensity sensed by the light intensity detector to a predefined range of light intensity;
if the light intensity sensed by the light intensity detector is within the predefined range of light intensity, keeping the brightness of the display device by the controller, and if the light intensity sensed by the light intensity detector is outside the predefined range of light intensity, adjusting the brightness of the display device by the controller so that the light intensity sensed by the light intensity detector falls within the predefined range of light intensity.

According to another embodiment, after sensing, by the light intensity detector, the light intensity of light reflected by the reflecting member, the light intensity of the light reflected by the reflecting member which is sensed by the light intensity detector can be displayed on the display device.

Optionally, the display device can be a liquid crystal display device which comprises a backlight source and a backlight driver for driving the backlight source. The light intensity detector senses light intensity of the light emitted from the backlight source and reflected by the reflecting member, and the controller controls the backlight driver according to a result of comparison between the light intensity sensed by the light intensity detector and the predefined range of light intensity so as to adjust light intensity of the backlight source.

The display device can also be an OLED display device which comprises an OLED and a driver for driving the OLED. The light intensity detector senses light intensity of the light emitted from the OLED and reflected by the reflecting member, and the controller controls the driver according to the result of comparison between the light intensity sensed by the light intensity detector and the predefined range of light intensity so as to adjust light intensity of the light emitted by the OLED.

In the display device and the method for controlling brightness of the display device according to embodiments of the present disclosure, light (e.g. light inside the display device) can be directly sensed by the reflecting member and the light intensity detector disposed on the first and second substrates arranged opposite to each other, and brightness of the display device can be controlled according to the result of sensing. Hence, compared to the way of sensing the ambient light, it can sense the light intensity more accurately and can facilitate better control of the brightness of the display device, thereby improving display quality. In addition, the reflecting member and the light intensity detector are directly disposed on the first and second substrates, so the reflecting member and the light intensity detector can be made in the process for manufacturing the substrates and it is unnecessary to separately make an additional sensing unit. Therefore, the time of process and the cost of manufacturing are saved.

Although exemplary embodiments of the present disclosure have been described in detail with reference to the drawings, such descriptions shall be considered as being illustrative rather than restrictive. The present disclosure is not limited to the disclosed embodiments. Different embodiments described in the above and in the claims can be combined. When carrying out the claimed disclosure, those skilled in the art can understand and implement other variations of the disclosed embodiments on the basis of studies on the figures, description and claims, so said variations shall fall into the protection scope of the present disclosure.

The word "include" or "comprise" used in the claims do not intend to exclude the existence of other components or steps. The fact that several technical measures are stated in mutually different dependent claims does not mean that combinations of said technical means cannot be used to advantage.

## Claims

1. A display device, comprising:
a first substrate and a second substrate arranged opposite to each other;
a reflecting member disposed on a side of the first substrate near the second substrate;
a light intensity detector disposed on a side of the second substrate near the first substrate and configured to sense light intensity of light reflected by the reflecting member; and
a controller electrically connected to the light intensity detector,
wherein said controller is configured to control brightness of the display device according to the light intensity sensed by the light intensity detector.

2. The display device according to claim 1, wherein the controller is configured to compare the light intensity sensed by the light intensity detector to a predefined range of light intensity, and wherein if the light intensity sensed by the light intensity detector is within the predefined range of light intensity, the controller keeps the brightness of the display device, and if the light intensity sensed by the light intensity detector is outside the predefined range of light intensity, the controller adjusts the brightness of the display device so that the light intensity sensed by the light intensity detector falls within the predefined range of light intensity, and
wherein the light intensity sensed by the light intensity detector is displayed by the display device.

3. The display device according to claim 1, wherein the display device is a liquid crystal display device, the first substrate is a color film substrate, and the second substrate is an array substrate.

4. The display device according to claim 3, wherein the display device further comprises a backlight source arranged on a side of the array substrate facing away from the color film substrate and a backlight driver configured to drive the backlight source, the light intensity detector is configured to sense light intensity of the light emitted from the backlight source and reflected by the reflecting member, and the controller is configured to control the backlight driver according to a result of comparison between the light intensity sensed by the light intensity detector and the predefined range of light intensity so as to adjust light intensity of the backlight source.

5. The display device according to claim 3, wherein the liquid crystal display device includes a display area and a peripheral area, and both the reflecting member and the light intensity detector are arranged in the peripheral area.

6. The display device according to claim 3, wherein the liquid crystal display device includes a display area and a peripheral area, and the display area includes a plurality of pixel regions, an edge region of each pixel region being provided with the reflecting member and the light intensity detector.

7. The display device according to claim 1, wherein the display device is an OLED display device, the first substrate is an encapsulation substrate and the second substrate is an array substrate.

8. The display device according to claim 7, wherein the array substrate comprises an OLED and a driver configured to drive the OLED, and wherein the light intensity detector is configured to sense light intensity of light emitted from the OLED and reflected by the reflecting member, and the controller is configured to control the driver according to the result of comparison between the light intensity sensed by the light intensity detector and the predefined range of light intensity so as to adjust light intensity of the light emitted by the OLED.

9. The display device according to claim 7, wherein the OLED display device include a display area and a peripheral area, and the display area includes a plurality of pixel regions, an edge region of each pixel region being provided with the reflecting member and the light intensity detector.

10. The display device according to claim 7, wherein the OLED display device include the display area and the peripheral area, and the reflecting member and the light intensity detector are both arranged in the peripheral area.

11. A method for controlling brightness of the display device, comprising:
sensing, by a light intensity detector arranged on a second substrate of the display device, light intensity of light reflected by a reflecting member on a first substrate; and
controlling, by a controller electrically connected to the light intensity detector, brightness of the display device according to the light intensity sensed by the light intensity detector.

12. The method for controlling brightness of the display device according to claim 11, wherein said controlling, by a controller electrically connected to the light intensity detector, brightness of the display device according to the light intensity sensed by the light intensity detector comprises:
comparing, by the controller, the light intensity sensed by the light intensity detector to a predefined range of light intensity;
if the light intensity sensed by the light intensity detector is within the predefined range of light intensity, keeping the brightness of the display device by the controller, and if the light intensity sensed by the light intensity detector is outside the predefined range of light intensity, adjusting the brightness of the display device by the controller so that the light intensity sensed by the light intensity detector falls within the predefined range of light intensity.

13. The method for controlling brightness of the display device according to claim 11, further comprising displaying, on the display device, the light intensity of the light reflected by the reflecting member and sensed by the light intensity detector.

14. The method for controlling brightness of the display device according to claim 11, wherein the display device is a liquid crystal display device which comprises a backlight source and a backlight driver configured to drive the backlight source, and wherein the method further comprises:
sensing, by the light intensity detector, light intensity of the light emitted from the backlight source and reflected by the reflecting member, and
controlling, by the controller, the backlight driver according to a result of comparison between the light intensity sensed by the light intensity detector and the predefined range of light intensity so as to adjust light intensity of the backlight source.

15. The method for controlling brightness of the display device according to claim 11, wherein the display device is an OLED display device which comprises an OLED and a driver configured to drive the OLED, and wherein the method further comprises:
sensing, by the light intensity detector, light intensity of the light emitted from the OLED and reflected by the reflecting member, and
controlling, by the controller, the driver according to a result of comparison between the light intensity sensed by the light intensity detector and the predefined range of light intensity so as to adjust light intensity of the light emitted by the OLED.
